# EUROPÄISCHE PATENTSCHRIFT

(11) **EP 1 131 824 B1**
(45) Veröffentlichungstag und Bekanntmachung des Hinweises auf die Patenterteilung: **12.03.2003**
(21) Anmeldenummer: 99969822.8
(22) Anmeldetag: 29.09.1999
(51) Int. Cl.: G11C 11/402

(54) **SINGLE-PORT SPEICHERZELLE**
SINGLE-PORT MEMORY LOCATION
CELLULE MEMOIRE A SIMPLE ACCES

(30) Priorität: 30.09.1998 DE 19845035
(43) Veröffentlichungstag der Anmeldung: 12.09.2001
(73) Patentinhaber: Infineon Technologies AG, 81669 München (DE)
(72) Erfinder: RAJ, Kumar-Jain, Singapore 349249 (SG)
(74) Vertreter: Barth, Stephan Manuel, Dr.
(86) Internationale Anmeldenummer: DE9903133
(87) Internationale Veröffentlichungsnummer: WO00019444

(56) Entgegenhaltungen:
- EP-A- 0 188 769
- US-A- 4 203 159
- US-A- 4 292 677
- US-A- 5 646 903
- "READ/WRITE DYNAMIC MEMORY USING TWO DEVICES PER CELL AND HAVING INTERNAL REFRESH" IBM TECHNICAL DISCLOSURE BULLETIN, Bd. 23, Nr. 10, 1. März 1981 (1981-03-01), Seiten 4620-4621, XP002128839

## Beschreibung

Die Erfindung betrifft eine Single-Port Speicherzelle und einen Halbleiterspeicher mit Single-Port Speicherzellen.

Als Single-Port Speicherzellen werden alle Speicherzellen bezeichnet, die lediglich eine einzige Auswahlleitung und eine einzige Datenleitung aufweisen. Nachfolgend werden alle Single-Port-Speicherzellen, sofern dies nicht ausdrücklich anders angegeben ist, kurz als Speicherzellen bezeichnet.

Eine dynamische Single-Port Speicherzelle (dynamic random access memory; DRAM) enthält einen Auswahltransistor und ein kapazitives Element. Das kapazitive Element ist hier typischerweise als Speicherkondensator ausgebildet. Alternativ wäre es auch denkbar, daß das kapazitive Element als konventioneller Speichertransistor, dessen Gateanschluß an ein Versorgungspotential angeschlossen ist, realisiert ist.

Der besondere Vorteil von DRAM-Speicherzellen besteht in deren äußerst platzsparenden Realisierung auf einem Halbleiterchip, wodurch sich DRAM-Halbleiterspeicher äußerst kostenkünstig fertigen lassen. Aufgrund der geringen Anzahl der Schaltungselemente einer DRAM-Speicherzelle und somit des geringen Verdrahtungsaufwandes weisen DRAM-Halbleiterspeicher vorteilhafterweise sehr kurze Zugriffszeiten auf, wodurch deren Leistungsfähigkeit zusätzlich optimiert werden kann. Allerdings befindet sich bei DRAM-Speicherzellen jeweils ein Anschluß des kapazitiven Elementes auf einem "floatenden", d. h. auf einem nicht definierten Potential. DRAM-Speicherzellen müssen daher in regelmäßigen Abständen wiederaufgeladen werden (Refresh-Vorgang). Während dieses Refresh-Vorganges kann die DRAM-Speicherzelle nicht ausgelesen oder beschrieben werden, wodurch sich undefinierte Schaltzustände nie ganz vermeiden lassen.

Die US-A-4,203,159 beschreibt eine Single-Port Speicherzellenanordnung mit Single-Port Speicherzellen mit einem kapazitiven Element und einem Auswahltransistor, die zwischen einer Datenleitung und einer Versorgungsleitung angeordnet sind. Jede Zelle weist einen steuerbaren Schalter auf, über den das kapazitive Element wieder aufladbar ist.

Die US-A-4,292,677 offenbart darüber hinaus, als kapazitives Element eine MOS-Anordnung zu verwenden. Diese MOS-Anordnung umfaßt eine Metallplatte, welche getrennt durch eine Oxydschicht über einem halbleitenden Bereich einer Hauptfläche eines Halbleitersubstrats liegt. Durch entsprechende Potentiale an der Metallplatte und dem Halbleitersubstrat wird ein verarmter Bereich in dem Halbleiterbereich unter der Metallplatte erzeugt. In diesem Bereich können Ladungen zur Erzeugung logischer Zustände gespeichert werden.

Eine statische Single-Port Speicherzelle (static random access memory; SRAM) enthält typischerweise sechs Transistoren: jeweils zwei Auswahltransistoren (Transfer-Gates) und vier Speichertransistoren (Inverter). Eine solche SRAM-Speicherzelle weist zwar definierte Potentialzustände in ihrem Ausgangspfad auf, wodurch die in der Speicherzelle gespeicherte Information erhalten bleibt, jedoch werden für eine SRAM-Speicherzelle im Vergleich zu der oben beschriebenen DRAM-Speicherzelle deutlich mehr Transistorelemente benötigt. Eine solche SRAM-Speicherzelle weist daher auch aufgrund des sehr viel größeren Verdrahtungsaufwandes gegenüber einer DRAM-Speicherzelle ein flächenaufwendigeres Design auf. Insbesondere sehr komplexe Halbleiterspeicher, bei denen die Flächenoptimierung die wichtigste Randbedingung darstellt, sind daher vorzugsweise aus DRAM-Speicherzellen aufgebaut.

Die vorliegende Erfindung stellt sich daher die Aufgabe, ein neues Design einer Single-Port Speicherzelle bereitzustellen.

Erfindungsgemäß wird diese Aufgabe durch eine Single-Port-Speicherzelle mit den Merkmalen des Patentanspruchs 1 gelöst.

Die erfindungsgemäße Single-Port-Speicherzelle weist in der bevorzugten Ausgestaltung jeweils einen MOS-Speichertransistor und einen MOS-Auswahltransistoren auf, deren Laststrecken in Reihe geschalten sind und diese Reihenschaltung zwischen einer Datenleitungen und einer Ladeeinrichtung angeordnet ist. Durch diese Anordnung läßt sich eine Single-Port-Speicherzelle bereitstellen, bei der ein kapazitives Element mittels einer Datenverarbeitungseinrichtung ausgelesen bzw. beschrieben werden kann und gleichzeitig dieses kapazitive Element mittels der Ladeeinrichtung wieder aufgeladen werden kann (Refresh-Vorgang).

Die neue Speicherzelle verknüpft somit zumindest zum Teil die eingangs erwähnte Funktionalität einer DRAM-Speicherzelle mit der einer SRAM-Speicherzelle. Aus der Anwenderperspektive verhält sich die erfindungsgemäße Speicherzelle wie eine einfache SRAM-Speicherzelle, da sie zu jedem Zeitpunkt definierte Schaltzustände aufweist. Die Speicherzelle ist somit jederzeit von einer Datenverarbeitungseinheit ansprechbar. Gegenüber einer herkömmlichen SRAM-Speicherzelle weist die erfindungsgemäße Speicherzelle zusätzlich den Vorteil einer deutlich verringerten Chipfläche auf. Herkömmliche SRAM-Speicherzellen weisen insgesamt sechs Transistoren auf, während für die erfindungsgemäße Speicherzelle nur maximal zwei bzw. drei Transistoren erforderlich.sind. Somit ist eine Flächenersparnis von über 50 % realisierbar.

Die erfindungsgemäße Speicherzelle ist insbesondere darum besonders vorteilhaft, weil das kapazitive Element als MOS-Transistor ausgebildet ist. Bei einem solchen MOS-Transistor können dessen Laststreckenanschlußknoten, d. h. der Sourceanschluß und der Drainanschluß, in platzsparender Weise mit den jeweiligen in Reihe geschalteten Auswahltransistor und Schalttransistor zusammenfallen. Durch diese Einsparung von flächenintensiven Anschlußknoten können ein optimales Flächendesign bereitgestellt werden.

Darüber hinaus.weist die erfindungsgemäße Speicherzelle aufgrund der geringen Leiterbahnlängen eine gegenüber herkömmlichen SRAM-Speicherzellen optimierte Zugriffszeit auf. Derartig niedrige Zugriffszeiten bzw. ein derartig geringer Flächenbedarf auf dem Halbleiterchip sich bislang lediglich durch herkömmliche DRAM-Speicherzellen erreichen.

Das kapazitive Element der erfindungsgemäßen Speicherzelle weist ständig ein definiertes, nicht-floatendes Potential auf. Ferner werden durch voneinander getrennte Leitungen die Schreib-/Lesevorgänge von den Refresh-Vorgängen entkoppelt. Die erfindungsgemäßen Speicherzellen müssen daher nicht bei jedem Refresh-Vorgang einen laufenden Lesevorgang bzw. Schreibvorgang unterbrechen. Auf diese Weise können im Gegensatz zu herkömmlichen DRAM-Speicherzellen zu jedem Zeitpunkt definierte Schaltzustände gewährleistet werden. Die erfindungsgemäße Speicherzelle weist somit nach außen hin die Funktionalität einer herkömmlichen DRAM-Speicherzelle und einer herkömmlichen SRAM-Speicherzelle auf.

Die erfindungsgemäße Speicherzelle ist aufgrund ihres Designs, d. h. aufgrund der geringen Anzahl der Schaltelemente und niedrigen Leiterbahnlängen, sehr rauschunempfindlich und weist somit ein deutlich besseres Signal-Rausch-Verhältnis (Signal Noise Ratio; SNR) im Vergleich zu herkömmlichen SRAM-Speicherzellen auf.

Die im Vergleich zu SRAM-Speicherzellen geringere Anzahl der benötigten Transistoren und die geringe Leiterbahnlänge bewirkt eine Reduzierung der Zugriffszeiten. Aufgrund der verringerten parasitären Kapazitäten und Widerstände im kritischen Leitungspfad wird die Zugriffszeit überdies noch verbessert.

Die Erfindung eignet sich insbesondere bei Single-Port-Halbleiterspeichern, die ein Zellenfeld mit einer Vielzahl von erfindungsgemäßen Single-Port-Speicherzellen aufweist, wobei die Ladeeinrichtungen zum Wiederaufladen der Speicherzellen außerhalb des Zellenfeldes angeordnet sind.

Die weiteren Unteransprüche sind auf bevorzugte Ausgestaltungen und Weiterbildungen der Erfindung gerichtet.

Die Erfindung wird nachfolgend anhand der in den Figuren der Zeichnung angegebenen Ausführungsbeispiele näher erläutert. Es zeigt dabei:
- Figur 1: das Schaltbild eines ersten Ausführungsbeispiels einer Speicherzelle;
- Figur 2: das Schaltbild eines zweiten Ausführungsbeispiels einer weiteren Speicherzelle;
- Figur 3: das Schaltbild eines Ausführungsbeispiels mit einer Vielzahl von miteinander verknüpften, erfindungsgemäßen Speicherzellen.

In allen Figuren der Zeichnung sind gleiche oder funktionsgleiche Elemente, sofern dies nicht anders angegeben ist, mit gleichen Bezugszeichen versehen.

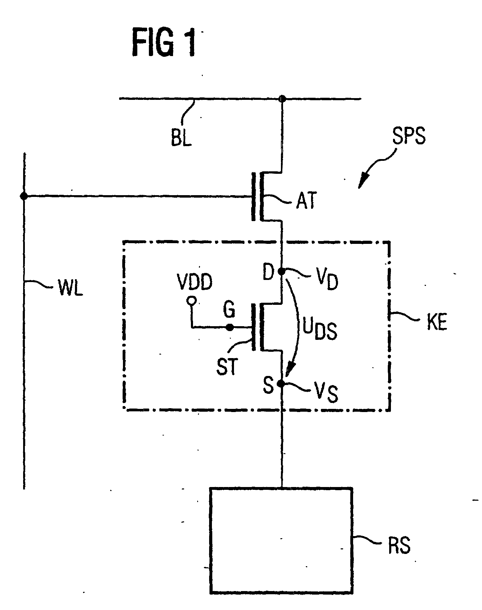

Figur 1 zeigt das Schaltbild einer Speicherzelle. Die Speicherzelle SPS weist einen Auswahltransistor AT sowie ein kapazitives Element KE auf. In Figur 1 ist das kapazitive Element KE als Speichertransistor ST ausgebildet, dessen Gateanschluß G mit einem Versorgungspotential VDD verbunden ist. Der Drainanschluß D des Speichertransistors ST ist über die Laststrecke des Auswahltransistors AT mit einer Datenleitung BL verbunden. Der Sourceanschluß S des Speichertransistors ST ist mit einer Ladeeinrichtung RS verbunden. Der Steueranschluß des Auswahltransistors AT ist über ein Auswahlsignal einer Wortleitung WL ansteuerbar. Die Laststrecken des Auswahltransistors AT sowie des Speichertransistors ST sind somit in Reihe geschaltet und zwischen der ersten Datenleitung BL und der Ladeeinrichtung RS angeordnet.

Die Speicherzelle SPS ist über die Datenleitungen BL mit einer nachgeschalteten Datenverarbeitungseinheit (in Figur 1 nicht dargestellt) verbunden. Diese Datenverarbeitungseinheit kann beispielsweise als Mikrocomputer, Prozessor, Logikschaltung, Bus, etc. ausgebildet sein. Über die Datenleitung BL lassen sich bidirektionell Daten aus der Speicherzelle SPS, d. h. aus dem Speichertransistor ST, einlesen bzw. auslesen.

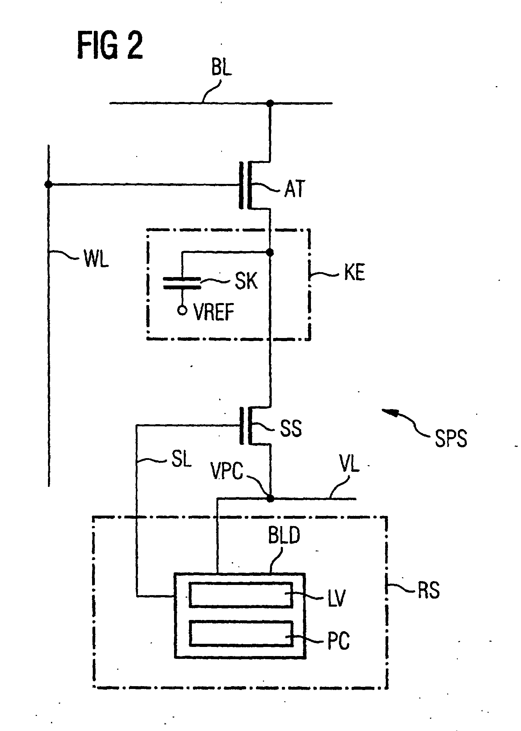

Figur 2 zeigt das Schaltbild einer weiteren Speicherzelle, in der auch eine vorteilhafte Ausgestaltung der Ladeeinrichtung RS dargestellt ist.

In Figur 2 ist das kapazitive Element KE als Speicherkondensator SK ausgebildet. Der Speicherkondensator SK ist zwischen der Laststrecke des Auswahltransistors AT und der Ladeeinrichtung RS angeordnet und mit einem Referenzpotential VREF verbunden. Die Ladeeinrichtung RS, die im Fachjargon auch als Refresh-Schaltung RS bezeichnet wird, enthält einen Bitleitungsdekoder BLD. Im vorliegenden Beispiel weist der Bitleitungsdekoder BLD zumindest einen Leseverstärker LV und eine Voraufladeschaltung PC (Precharge-Circuit) auf. Die Voraufladeschaltung PC stellt ausgangsseitig ein Ladepotential VPC bereit.

Im vorliegenden Beispiel ist ein in der Speicherzelle SPS angeordneter und als MOSFET ausgebildeter steuerbarer Schalter SS vorgesehen. Die Laststrecke des steuerbaren Schalters SS ist zwischen einem Anschluß des kapazitiven Elements KE und über eine Versorgungsleitung VL mit dem Bitleitungsdekoder BLD verbunden. Über eine Steuerleitung SL ist der Steueranschluß des steuerbaren Schalters SS von dem Bitleitungsdekoder BLD ansteuerbar. Über den Leseverstärker LV kann der in dem kapazitiven Element der Speicherzelle SPS gespeicherte Signalpegel gemessen werden. Falls der Signalpegel eine vorgegebene Schwelle unterschreitet, kann der steuerbare Schalter SS mittels eines Steuersignals über die Steuerleitung SL in den leitenden Zustand gesteuert werden. Das kapazitive Element KE wird über die Laststrecke des steuerbaren Schalters SS mit dem Ladepotential VPC der Voraufladeschaltung PC beaufschlagt und dadurch wieder aufgeladen.

Besonders vorteilhaft ist es, wenn eine sogenannte Autorefresh-Schaltung RS vorgesehen ist, mittels der das Wiederaufladen der Speicherzelle SPS automatisch erfolgen kann. Über einen einfachen taktgesteuert Ringzähler lassen sich fortwährend in auf- oder absteigender Folge die einzelnen Adressen der verschiedenen Speicherzellen SPS generieren, die dann in den entsprechenden Zeitabständen durch die Voraufladeschaltung PC oder durch eine Referenzspannungsquelle wieder aufgeladen werden. Durch diese Maßnahme ist ein schaltungstechnisch aufwendiger Leseverstärker LV nicht mehr erforderlich. Durch diese automatisierten Refresh-Vorgänge läßt sich außerdem das kapazitive Element KE der Speicherzelle SPS weiter verkleinern, da dessen Größe nicht überdimensioniert werden muß, um einem unerwünscht Datenverlust vorzubeugen.

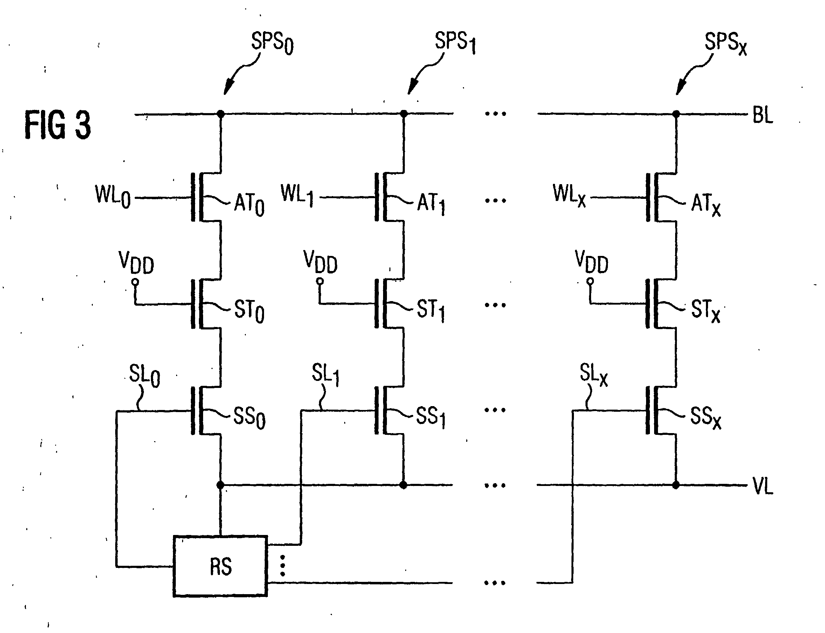

Figur 3 zeigt das Schaltbild eines Ausführungsbeispiels mit einer Vielzahl von miteinander verknüpften erfindungsgemäßen Speicherzellen.

Figur 3 zeigt eine Vielzahl von Speicherzellen SPS₀...SPSₓ. Jede dieser Speicherzellen weist dabei einen Auswahltransistor AT₀...ATₓ, einen Speichertransistor ST₀...STₓ und einen steuerbaren Schalter SS₀...SSₓ auf. Diese über ihre Laststrecken in Reihe geschalteten Transistoren sind zwischen einer Datenleitung BL und einer Versorgungsleitung VL angeordnet. Die Auswahltransistoren AT₀...ATₓ werden über Signale der jeweiligen Auswahlleitungen WL₀...WLₓ angesteuert. Die Steueranschlüsse der Speichertransistoren ST₀...STₓ sind mit einer Versorgungsspannung VDD beaufschlagt. Die Steueranschlüsse der steuerbaren Schalter SS₀...SSₓ werden über entsprechende Steuerleitungen SL₀...SLₓ von der Ladeeinrichtung RS angesteuert. Der besondere Vorteil dieser Anordnung liegt darin, daß eine einzige Ladeeinrichtung RS zur Ansteuerung der entsprechendene Speicherzellen SPS₀...SPSₓ vorgesehen ist, wodurch die erfindungsgemäße Speicheranordnung flächenoptimiert ausgebildet sein kann.

Nachfolgend wird die Funktionsweise der erfindungsgemäßen Speicherzelle SPS anhand von Figur 1 kurz erläutert:

Während eines Schreibvorganges über die Datenleitung DL wird der Auswahltransistor AT in den leitenden Zustand gesteuert. Das kapazitive Element KE wird dadurch mit dem Potential VDD - Vth geladen, wenn eine digitale "1" in die entsprechende Speicherzelle SPS geschrieben werden soll, oder wird auf das Potential VSS entladen, wenn beispielsweise eine digitale "0" in die entsprechende Speicherzelle SPS geschrieben werden soll.

Die Erfindung nutzt die Tatsache aus, daß für annähernd gleiche Potentiale am Gateanschluß G und Sourceanschluß S des Speichertransistors ST der Spannungsabfall UDS zwischen Source- und Drain-Anschluß äquivalent zu dessen Einsatzspannung Vth ist. Da der Gateanschluß G des Speichertransistors ST mit dem Versorgungspotential VDD verbunden ist, weisen Source-Anschluß S und Drain-Anschluß D des Speichertransistors ST dasselbe Potential auf, d. h. VS = VD = VDD - VT für eine digitale "1" und VS = VD = VSS für eine digitale "0". Da das Drainpotential VD und das Sourcepotential VS auf demselben Potential liegen, kann sowohl von der Datenverarbeitungseinheit als auch von der Refresh-Schaltung RS auf die Speicherzelle SPS ohne eine Verringerung der Spannung des Speichertransistors ST zugegriffen werden.

Somit kann während einem Zugriff der Datenverarbeitungseinheit auf die Speicherzelle SPS, d. h. während eines Lesevorganges oder Schreibvorganges, die Refresh-Schaltung RS gleichzeitig auf die Speicherzelle SPS zugreifen und diese wiederaufladen. Auf diese Weise lassen sich vorteilhafterweise die Zugriffszeiten auf die Speicherzellen eines Haibleiterspeichers signifikant verringern.

Ein weiterer Vorteil der Erfindung ergibt sich aus der Tatsache, daß beide Ausgangsanschlüsse des Speichertransistors ST, d. h. der Drainanschluß D und der Sourceanschluß S, jeweils dasselbe Potential aufweisen. Aufgrund dieser Tatsache kann auf einen Kontaktanschluß verzichtet werden, was insbesondere in der DRAM- und SRAM-Speichertechnologie, wo Kontakte äußerst flächenaufwendig zu realisieren sind, in Hinblick auf die Flächenoptimierung von besonderem Vorteil ist.

In den vorliegenden Ausführungsbeispielen gemäß der Figuren 2 und 3 ist jeweils ein steuerbare Schalter SS in jeder Speicherzelle SPS angeordnet. Es wäre jedoch auch denkbar einen einzigen oder wenige steuerbare Schalter SS für alle oder mehrer Speicherzellen SPS zu verwenden. Denkbar wäre auch, den steuerbaren Schalter SS in dem Bitleitungsdekoder BLD anzuordnen.

Die Erfindung eignet sich insbesondere bei in CMOS-Technologie hergestellten Speicherzellen. Die Speicherzellen sind jedoch nicht auf eine bestimmte Transistortechnologie beschränkt, sondern können durch jede Art von feldeffektgesteuerten, selbstleitenden oder selbstsperrenden, typischerweise in MOS-Technologie hergestellten Transistoren realisiert werden. Denkbar wären jedoch auch bipolar ausgebildete Speicherzellen.

In einer Weiterbildung können selbstverständlich alle bekannten Maßnahmen nach dem Stand der Technik zur Flächenoptimierung sowie zur Verkürzung der Zugriffszeit, beispielsweise durch Optimierung der Designrules, angewendet werden, um die erfindungsgemäße Speicherzelle und somit den entsprechenden aus einer Vielzahl von solchen Speicherzellen aufgebauten Halbleiterspeicher weiterzubilden.

## Patentansprüche

1. Single-Port Speicherzellenanordnung
(a) mit einer Vielzahl von Single-Port Speicherzellen (SPS0, SPS1, ..., SPSx),
(a1) die jeweils einen Speichertransistor (ST0, ST1, ..., STx) und einen Auswahltransistor (AT0, AT1, ..., ATx), die über ihre Laststrecken in Reihe geschaltet sind und die zwischen einer Datenleitung (BL) und einer Versorgungsleitung (VL) angeordnet sind, aufweisen,
(a2) wobei der Steueranschluß jedes Auswahltransistor (AT0, AT1, ..., ATx) mit einer jeweiligen Wortleitung (WL0, WL1, ... WLx) verbunden ist,
(a3) wobei der jeweilige Speichertransistor (ST0, ST1, ..., STx) am Steueranschluß (G) mit einem Versorgungspotential (VDD) beaufschlagt ist,
(b) mit mindestens einem zwischen der Versorgungsleitung (VL) und der Laststrecke jedes Speichertransistors (ST0, ST1, ..., STx) angeordneten steuerbaren Schalter (SS0, SS1, ..., SSx),
(b1) wobei die Laststrecke des jeweiligen Speichertransistors (ST0, ST1, ..., STx) zwischen den Laststrecken des steuerbaren Schalters (SS0, SS1, ..., SSx) und des jeweiligen Auswahltransistors (AT0, AT1, ..., ATx) angeordnet ist,
(c) mit einer einzigen, der Vielzahl der Single-Port Speicherzellen (SPS0, SPS1, ..., SPSx) zugeordneten Ladeeinrichtung (RS),
(c1) die eine Voraufladeschaltung (PC) zur Bereitstellung eines Vorladepotentials (VPC) aufweist und
(c2) die über die Versorgungsleitung (VL) und den jeweiligen steuerbaren Schalter (SS0, SS1, ..., SSx) den entsprechenden Speichertransistor (ST0, ST1, ..., STx) der zugeordneten Single-Port Speicherzellen (SPS0, SPS1, ..., SPSx) von Zeit zu Zeit mit dem Ladepotential (VPC) wiederauflädt,
(d) die Speichertransistoren (ST0, ST1, ..., STx) sind über die Datenleitung (BL) für eine digitale "1" auf ein erstes Potential (VDD-Vth) und für eine digitale "0" auf ein zweites Potential (VSS) ladbar,
(d1) wobei das erste Potential (VDD-Vth), das zweite Potential (VSS) und das Versorgungspotential (VDD) derart gewählt sind, daß der Source- und Drainanschluß (S, D) des jeweiligen Speichertransistors (ST0, ST1, ..., STx) dasselbe Potential aufweisen.

2. Single-Port Speicherzellenanordnung nach Anspruch 1,
**dadurch gekennzeichnet,**
**daß** jede der Single-Port Speicherzellen (SPS0, SPS1, ..., SPSx) einen innerhalb der Speicherzelle angeordeten steuerbaren Schalter (SS0, SS1, ..., SSx) aufweist.

3. Single-Port Speicherzellenanordnung nach einem der nach einem der vorstehenden Ansprüche,
**dadurch gekennzeichnet,**
**daß** der jeweilige Speichertransistor (ST0, ST1, ..., STx) und zugehörige Auswahltransistor (AT0, AT1, ..., ATx) als MOS-Transistoren ausgebildet sind.

4. Single-Port Speicherzellenanordnung nach einem der vorstehenden Ansprüche,
**dadurch gekennzeichnet,**
**daß** Ladeeinrichtung (RS) außerhalb eines die Single-Port Speicherzellen (SPS0, SPS1, ..., SPSx) enthaltenden Zellenfeldes angeordnet ist.

5. Single-Port Speicherzellenanordnung nach Anspruch 4,
**dadurch gekennzeichnet,**
**daß** die Ladeeinrichtung (RS) einen Leseverstärker (LV) aufweist und der eine Leseverstärker (LV) und/oder die Voraufladeschaltung (PC) Bestandteil eines Bitleitungsdekoders (BLD) eines Halbleiterspeichers sind.

6. Single-Port Speicherzellenanordnung nach einem der vorstehenden Ansprüche,
**dadurch gekennzeichnet,**
**daß** die Ladeeinrichtung (RS) einen taktgesteuerten Ringzähler aufweist, der über seinen Zählerstand in regelmäßigen Zeitabständen eine Adresse für jeweils eine der Speicherzellen (SPS) generiert und über den die Ladeeinrichtung (RS) den jeweiligen Speichertransistor (ST0, ST1, ..., STx) automatisch wiederauflädt.

7. Single-Port Halbleiterspeicher mit mindestens einer Single-Port Speicherzellenanordnung nach einem der vorstehenden Ansprüche, der ein die Single-Port Speicherzellen (SPS0, SPS1, ..., SPSx) enthaltendes Zellenfeld aufweist und der eine Mehrzahl von den jeweiligen Single-Port Speicherzellenanordnungen zugeordneten Ladeeinrichtungen (RS) aufweist, wobei die Ladeeinrichtungen (RS) außerhalb des Zellenfeldes angeordnet sind.

## Claims

1. Single-port memory cell arrangement
(a) having a multiplicity of single-port memory cells (SPS0, SPS1, ..., SPSx),
(a1) which each have a memory transistor (ST0, ST1, ..., STx) and a selection transistor (AT0, AT1, ..., ATx), which are connected in series via their load paths and are arranged between a data line (BL) and a supply line (VL),
(a2) the control terminal of each selection transistor (AT0, AT1, ..., ATx) being connected to a respective word line (WL0, WL1, ..., WLx),
(a3) a supply potential (VDD) being applied to the respective memory transistor (ST0, ST1, ..., STx) at the control terminal (G),
(b) having at least one controllable switch (SS0, SS1, ..., SSx) arranged between the supply line (VL) and the load path of each memory transistor (ST0, ST1, ..., STx),
(b1) the load path of the respective memory transistor (ST0, ST1, ..., STx) being arranged between the load paths of the controllable switch (SS0, SS1, ..., SSx) and the respective selection transistor (AT0, AT1, ..., ATx),
(c) having a single charging device (RS) assigned to the multiplicity of single-port memory cells (SPS0, SPS1, ..., SPSx),
(c1) which charging device has a precharge circuit (PC) for providing a precharging potential (VPC) and
(c2) which charging device, via the supply line (VL) and the respective controllable switch (SS0, SS1, ..., SSx), recharges the corresponding memory transistor (ST0, ST1, ..., STx) of the assigned single-port memory cells (SPS0, SPS1, ..., SPSx) from time to time with the charging potential (VPC),
(d) the memory transistors (ST0, ST1, ..., STx) can be charged, via the data line (BL) to a first potential (VDD-Vth) for a digital "1" and to a second potential (VSS) for a digital "0",
(d1) the first potential (VDD-Vth), the second potential (VSS) and the supply potential (VDD) being chosen in such a way that the source and drain terminals (S, D) of the respective memory transistor (ST0, ST1, ..., STx) have the same potential.

2. Single-port memory cell arrangement according to Claim 1,
**characterized**
**in that** each of the single-port memory cells (SPS0, SPS1, ..., SPSx) has a controllable switch (SS0, SS1, ..., SSx) arranged within the memory cell.

3. Single-port memory cell arrangement according to one of the preceding claims,
**characterized**
**in that** the respective memory transistor (ST0, ST1, ..., STx) and associated selection transistor (AT0, AT1, ..., ATx) are designed as MOS transistors.

4. Single-port memory cell arrangement according to one of the preceding claims,
**characterized**
**in that** the charging device (RS) is arranged outside a cell array containing the single-port memory cells (SPS0, SPS1, ..., SPSx).

5. Single-port memory cell arrangement according to Claim 4,
**characterized**
**in that** the charging device (RS) has a sense amplifier (LV) and the one sense amplifier (LV) and/or the precharge circuit (PC) are part of a bit line decoder (BLD) of a semiconductor memory.

6. Single-port memory cell arrangement according to one of the preceding claims,
**characterized**
**in that** the charging device (RS) has a clocked ring counter which, via its counter reading, generates an address for a respective one of the memory cells (SPS) at regular time intervals and via which the charging device (RS) automatically recharges the respective memory transistor (ST0, ST1, ..., STx).

7. Single-port semiconductor memory having at least one single-port memory cell arrangement according to one of the preceding claims, which has a cell array containing the single-port memory cells (SPS0, SPS1, ..., SPSx) and which has a plurality of charging devices (RS) assigned to the respective single-port memory cell arrangements, the charging devices (RS) being arranged outside the cell array.

## Revendications

1. Dispositif de cellules de mémoire à port d'accès unique
(a) avec une pluralité de cellules de mémoire à port d'accès unique (SPS0, SPS1, ..., SPSx),
(a1) qui présentent chacune un transistor de mémoire (ST0, ST1, ..., STx) et un transistor de sélection (AT0, AT1,..., ATx) qui sont montés en série par l'intermédiaire de leur section de charge, et qui sont disposés entre une ligne de données (BL) et une ligne d'alimentation (VL).
(a2) le contact de commande de chaque transistor de sélection (AT0, AT1,..., ATx) étant connecté chaque fois à une ligne de mots (WL0, WL1, ..., WLx),
(a3) chaque transistor de mémoire (ST0, ST1, ..., STx) étant soumis au niveau du contact de commande (G) à un potentiel d'alimentation (VDD),
(b) avec au moins un commutateur sélectif (SS0, SS1, ..., SSx) disposé entre la ligne d'alimentation (VL) et le transistor de mémoire (ST0, ST1, ..., STx),
(b1) la section de charge de chaque transistor (ST0, ST1, ..., STx) étant disposée entre la section de charge du commutateur sélectif (SS0, SS1, ..., SSx) et chaque transistor de sélection (AT0, AT1,..., ATx),
(c) avec un seul dispositif de chargement (RS) affecté à la pluralité de cellules de mémoire à accès unique (SPS0, SPS1, ..., SPSx),
(c1) qui présente un circuit de préchargement (PC) pour la préparation d'un potentiel de préchargement (VPC) et
(c2) qui recharge de temps en temps par l'intermédiaire de la ligne d'alimentation (VL) et de chaque commutateur sélectif (SS0, SS1, ..., SSx) le transistor de mémoire (ST0, ST1, ..., STx) correspondant des cellules de mémoire à accès unique affectées (SPS0, SPS1, ..., SPSx) avec le potentiel de charge (VPC),
(d) les transistors de mémoire (ST0, ST1, ..., STx) sont rechargeables par l'intermédiaire de la ligne de données (BL) pour un "1" numérique à un premier potentiel (VDD-Vth) et pour un "0" numérique à un second potentiel (VSS),
(d1) le premier potentiel (VDD-Vth), le second potentiel (VSS) et le potentiel d'alimentation (VDD) étant sélectionnés de façon à ce que les contacts de source et de drain (S, D) de chaque transistor de mémoire (ST0, ST1, ..., STx) présentent le même potentiel.

2. Dispositif de cellules de mémoire à port d'accès unique selon la revendication 1, **caractérisé en ce que** chaque cellule de mémoire à accès unique (SPS0, SPS1, ..., SPSx) présente un commutateur sélectif (SS0, SS1, ..., SSx) disposé à l'intérieur de la cellule de mémoire.

3. Dispositif de cellules de mémoire à port d'accès unique selon l'une des revendications précédentes, **caractérisé en ce que** chaque transistor de mémoire (ST0, ST1, ..., STx) et chaque transistor de sélection (AT0, AT1,..., ATx) lui appartenant sont conçus sous la forme d'un transistor MOS.

4. Dispositif de cellules de mémoire à port d'accès unique selon l'une des revendications précédentes, **caractérisé en ce que** le dispositif de chargement (RS) est disposé à l'extérieur d'un champ de cellules contenant les cellules de mémoire à port d'accès unique.

5. Dispositif de cellules de mémoire à port d'accès unique selon la revendication 4, **caractérisé en ce que** le dispositif de chargement (RS) présente un amplificateur de lecture (LV) et **en ce que** ledit amplificateur de lecture (LV) et/ou le circuit de chargement (PC) font partie intégrante d'un décodeur de ligne de bits (BLD).

6. Dispositif de cellules de mémoire à port d'accès unique selon l'une des revendications précédentes, **caractérisé en ce que** le dispositif de chargement (RS) présente un compteur en anneau commandé par horloge, qui génère par l'intermédiaire de sa position de compteur à des intervalles de temps réguliers une adresse pour chacune des cellules de mémoire (SPS), et par l'intermédiaire duquel le dispositif de chargement (RS) recharge automatiquement chacun des transistors de mémoire (ST0, ST1, ..., STx).

7. Mémoire à semi-conducteurs à port d'accès unique avec au moins un dispositif de cellules de mémoire à port d'accès unique selon l'une des revendications précédentes, qui présente un champ de cellules contenant les cellules de mémoire à port d'accès unique (SPS0, SPS1, ..., SPSx), et qui présente une pluralité de dispositifs de chargement (RS) affectés à chacun des dispositifs de cellules de mémoire, les dispositifs de chargement (RS) étant disposés à l'extérieur du champ de cellules.
